# EUROPEAN PATENT APPLICATION

(11) **EP 3 029 735 A1**
(43) Date of publication of application: **08.06.2016**
(21) Application number: 14196397.5
(22) Date of filing: 04.12.2014
(51) Int. Cl.: H01L 29/74, H01L 29/861, H01L 29/87, H01L 29/417

(54) **Semiconductor device**

(71) Applicant: NXP B.V., 5656 AG Eindhoven (NL)
(72) Inventor: Ritter,, Hans-Martin, Redhill, Surrey RH1 1SH (GB); Wynants,, Jochen, Redhill, Surrey RH1 1SH (GB); Holland,, Steffen, Redhill, Surrey RH1 1SH (GB)
(74) Representative: Crawford, Andrew

(57) **Abstract**

The disclosure relates to a semiconductor device (500) comprising: a substrate (502) with a first surface (504) and an opposing second surface (506); and a unit (515) comprising: a first trench (518) extending from the first surface (504) towards the second surface (506) and a second trench (520) extending from the second surface (506) towards the first surface (504), wherein the first and second trenches (518, 520) contain conductive material (532, 534); a first contact disposed on the first surface (504) of the substrate (502) in electrical contact with the first trench (518); a second contact disposed on the second surface (506) of the substrate in electrical contact with the second trench (520); and a first active region (522) comprising a plurality of layers (526, 528, 530) extending transverse to the first surface (504) and separating the conductive material (532) in the first trench (518) from the conductive material (534) in the second trench (520).

## Description

This disclosure relates to the field of semiconductor devices and associated methods of fabrication. In particular, although not exclusively, this disclosure relates to semiconductor devices having a lateral conduction path within a substrate.

Semiconductor devices, such as diodes, transistors, thyristors and silicon controlled rectifiers, are essential components in a variety of circuits. A difficulty encountered in some applications of conventional semiconductor devices is that the devices have to be physically large in order to handle substantial currents.

According to a first aspect there is provided a semiconductor device comprising:
a substrate with a first surface and an opposing second surface; and
a unit comprising:
   a first trench extending from the first surface towards the second surface and a second trench extending from the second surface towards the first surface, wherein the first and second trenches contain conductive material;
   a first contact disposed on the first surface of the substrate in electrical contact with the first trench;
   a second contact disposed on the second surface of the substrate in electrical contact with the second trench; and
   a first active region comprising a plurality of layers extending transverse to the first surface and separating the conductive material in the first trench from the conductive material in the second trench.

The first trench may terminate within the substrate. The second trench may terminate within the substrate. The first trench may extend through the substrate such that it is exposed at the first and second surfaces. The second trench may extend through the substrate such that it is exposed at the first and second surfaces.

The plurality of layers of the first active region may form a PN junction. A P side of the junction may be adjacent to the first trench. An N side of the junction may be adjacent to the second trench.

The first active region may comprise one or more of: a bipolar transistor, a thyristor, a silicon controlled rectifier, two opposing diodes or a Shockley diode.

The unit may comprise a third trench extending from the first surface towards the second surface, wherein the third trench contains conductive material.

The semiconductor device may comprise an additional contact. The additional contact may be disposed on the first surface. The additional contact may be connected to the second contact through the substrate.

The first active region may at least partly form a vertical trench device.

The semiconductor device may comprise a plurality of units. Each unit may comprise a second active region disposed in the substrate on an opposite side of the second trench to the first active region. The plurality of units may be arranged such that the second active region of a particular unit is provided directly between the second trench of that unit and a first trench of a neighbouring unit. The second active region of each unit may comprise the same structure as the first active region of that unit. The second active region of each unit may comprise a reversal, or mirror, of a structure of the first active region of the respective unit. The plurality of units may have one or more axes of symmetry as viewed normal to a plane of the first surface.

According to a further aspect there is provided a method for manufacturing a semiconductor device from a semiconductor substrate having a first surface and an opposing second surface, the method comprises forming a unit in the semiconductor device by:
preparing a first trench extending from the first surface towards the second surface;
preparing a second trench extending from the second surface towards the first surface;
forming a first active region by diffusing dopant into the substrate via the first and/or second trenches, the first active region comprising a plurality of layers extending transverse to the first surface;
filling the first and second trenches with conductive material;
disposing a first contact on the first surface of the substrate in electrical contact with the conductive material in the first trench;
disposing a second contact on the second surface of the substrate in electrical contact with the conductive material in the second trench.

One or more embodiments of the disclosure will now be described, by way of example only, and with reference to the accompanying figures in which:
figure 1 illustrates a schematic cross-section of a planar diode with a vertical current conduction path;
figure 2 illustrates a schematic cross-section of a planar diode with a lateral current conduction path;
figure 3 illustrates a schematic cross-section of a trench diode with a lateral current conduction path;
figures 4a to 4d illustrate schematic cross-sections of semiconductor devices that each have trenches and a lateral conduction path;
figure 5a illustrates a schematic cross-section of a unit for a diode based on the arrangement of the semiconductor device of figure 4b;
figure 5b illustrates a plane of a substrate of the diode of figure 5;
figures 6a to 6e illustrate schematically a plane of a substrate for a number of semiconductor devices;
figure 7a illustrates a schematic cross-section of a diode compromising a plurality of units which are similar to the unit illustrated in figure 5a;
figure 7b illustrates a circuit diagram for the diode of figure 7a;
figure 8a illustrates a schematic cross-section of a dual diode;
figure 8b illustrates a circuit diagram for the dual diode of figure 8a;
figure 9a illustrates a schematic cross-section of an arrangement for a semiconductor device for providing (i) a bipolar transistor with a floating base or (ii) a Shockley diode;
figure 9b illustrates a circuit diagram for the bipolar transistor described with reference to figure 9a;
figure 10 illustrates a schematic cross-section of a bipolar transistor arrangement;
figure 11 a illustrates a schematic cross-section of another bipolar transistor arrangement;
figure 11b illustrates a circuit diagram for the bipolar transistor described with reference to figure 11 a;
figure 12a illustrates a schematic cross-section of a silicon controlled rectifier;
figure 12b illustrates a circuit diagram for the silicon controlled rectifier of figure 12a;
figure 13a illustrates a schematic cross-section for a thyristor assisted anti-serial diode;
figure 13b illustrates a circuit diagram for the thyristor assisted anti-serial diode of figure 13a; and
figure 14 illustrates a method for manufacturing a semiconductor device.

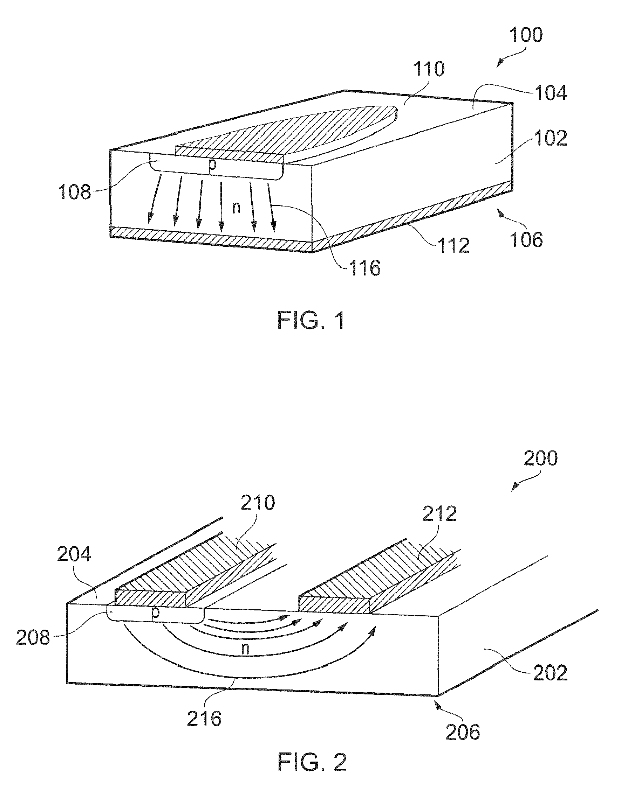

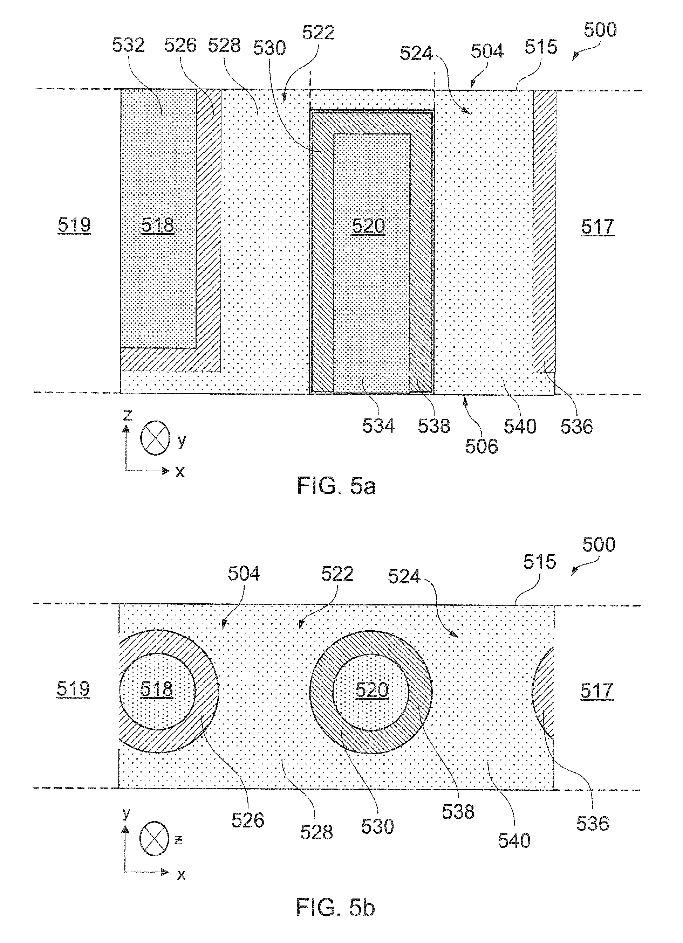

This disclosure relates to a range of semiconductor devices and specifically to the improved devices described with reference to figures 5 to 13. Such devices can be used for overvoltage and overcurrent protection as discrete or integrated devices and may provide combined capacitive load and overload protection in low pass filter circuits, for example. Advantages of these semiconductor devices may be better understood when compared to the problems faced by the diodes described with reference to figures 1 to 3. Corresponding reference numerals are used to refer to similar components in the various figures.

Diodes have a variety of applications including overvoltage/overcurrent protection. In such circuits excessive current can be drained to ground. Diodes in overvoltage protection circuits should therefore withstand high current densities and also the heat that results from such current densities.

Figure 1 illustrates a planar diode 100, which may also be referred to as a surface diode. The diode 100 has a substrate 102 with a first surface 104 and an opposing second surface 106 that is generally parallel with the first surface 104. The majority of the substrate 102 comprises N-type material. A P-type layer 108 is provided adjacent to the first surface 104. A PN junction is provided at an interface between the P-type layer 108 and the N-type material that makes up the majority of the substrate 102. A first contact 110 is disposed on the first surface 104 of the substrate in electrical contact with the P-type layer 108. A second contact 112 is disposed on the second surface 106 of the substrate 102 in electrical contact with the N-type layer. Vertical current paths 116, in which currents run transverse to the first surface 104, are provided through the substrate 102 between the first contact 110 and the second contact 112. The first contact 110 and the second contact 112 can be referred to as anode and cathode contacts.

An advantage of the planar diode 100 is that a relatively uniform current distribution is provided across the whole of the PN junction and all of this area can be used to carry current.

The majority of the heat produced by the diode 100 is generated in the space charge region at the junction, which for this arrangement is a relatively small volume adjacent to the first surface 104. The current density at the junction has to be relatively high in order to handle relatively high currents. The heat which results from the high current density is concentrated in this small volume near the first surface 104. As such, the temperature of the planar diode 100 can increase quickly due to heating when a high current is passed through the diode. In order to mitigate these problems, the size of the PN junction may be increased which results in a larger device footprint and so increased costs.

Figure 2 illustrates a planar diode 200 with a lateral current path running parallel to the first surface 204 of the substrate 202. The planar diode 200 of figure 2 differs from the planar diode of figure 1 in that the second contact 212 is provided on the first surface 204. The second contact 212 is offset from the first contact 210 across the first surface 204. The P-type region of the diode is adjacent to the first contact 210. The N-type region that forms the bulk of the substrate 202 is adjacent to the second contact 212. In this way, lateral current paths 216 are provided in the substrate 202 between the first and second contacts 210, 212.

An advantage of the arrangement of the planar diode 200 of figure 2 is that the first and second contacts 210, 212 are both provided on the first surface 204. Assembly and packaging of the diode 200 may therefore be simpler than that for the planar diode of figure 1.

A disadvantage of the arrangement of the planar diode 200 of figure 2 is that, for a given device footprint, the area of the PN junction is smaller than that for the planar diode of figure 1 because a smaller fraction of the area of the first surface 204 is used to carry current. The current distribution within the substrate 202 is non-uniform for the planar diode 200 of figure 2, typically, a much higher current density is seen adjacent to the contacts 210, 212 at the first surface 204 than deeper in the substrate 202 towards the second surface 206. The reason for this is that a lateral path near the first surface 204 has a lower resistance than a longer lateral path that arcs towards the second surface 206, as shown in figure 2. The localised current density hotspot near the first surface 204 reduces the overall current handling capability of the diode 200 and decreases its efficiency.

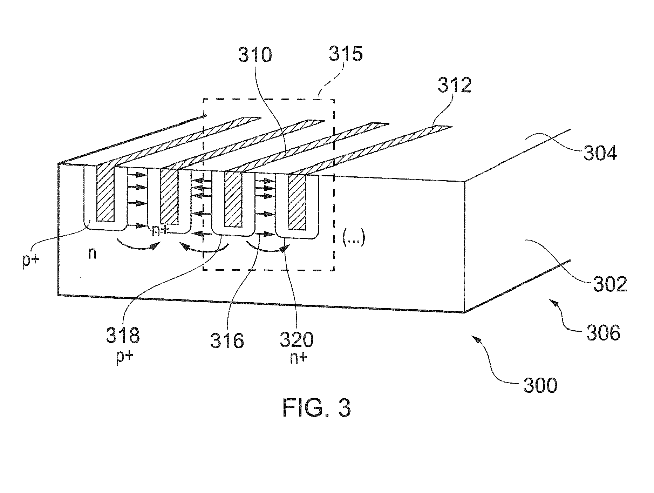

Figure 3 illustrates a trench diode 300. The diode 300 has a substrate 302 with a first surface 304 and an opposing second surface 306. The diode 300 in this example comprises a plurality of functional units 315. Each unit 315 comprises two trenches 318, 320 that each extend from the first surface 304 towards the second surface 306 and terminate within the substrate 302 (that is, the trenches 318, 320 do not pass through the substrate 302 to the second surface 306).

A first of the trenches 318 is lined with a P⁺-type material. An inner portion of the first trench 318 is filled with a conductive material. A first contact 310 is disposed on the first surface 304 of the substrate 302 in electrical contact with the conductive material in the first trench 318.

A second of the trenches 320 is lined with an N⁺-type material. An inner portion of the second trench 320 is also filled with conductive material. A second contact 312 is disposed on the first surface 304 of a substrate 302 in electrical contact with the conductive material in the second trench 320.

The plurality of functional units 315 are arranged so that the first and second trenches 318, 320 are interdigitated with one another. In this way, a plurality of lateral conduction paths 316 are provided between the first and second trenches 318, 320. An advantage of providing a plurality of PN junctions that extend transverse to the first surface 304 is that the total area of the PN junction can be increased without increasing the footprint of the diode 300 in terms of the surface area of the first surface 304.

A disadvantage of the arrangement of the trench diode 300 is that the current density is non-uniform. The current density is non-uniform because a current path between the first and second contacts 310, 312 adjacent to the first surface 304 has a shorter length, and therefore a lower resistance, then a current path between the first and second contacts 310, 312 that passes closer to the second surface 306. The current density is therefore highest adjacent to the first surface 304. For this reason, the area of the full PN junction is not optimally used because the portions towards the second surface 306 are at a lower current density than the portions nearer the first surface 304. This problem is exacerbated where deeper trenches are used, or where the conductivity of the conductive material in the first and second trenches 318, 320 is lower.

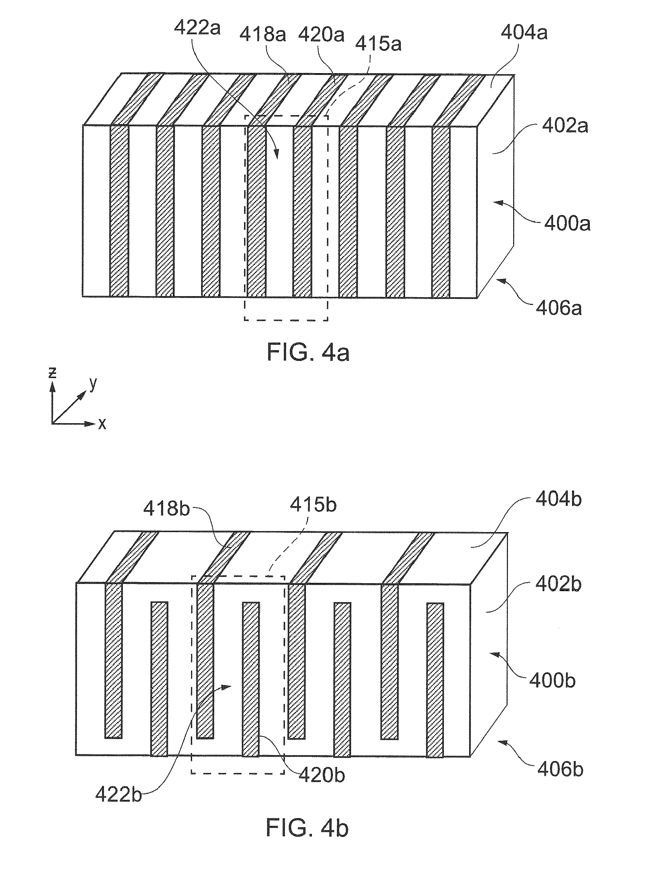

Figures 4a to 4d illustrate examples of improved semiconductor devices 400a, 400b, 400c, 400d. The devices have trenches with lateral current paths between them as in device shown in figure 3. However, the trenches of the devices 400a, 400b, 400c, 400d are each arranged such that adjacent trenches have their electrical contacts on opposite sides of the substrate. In this way a plurality of substantially equal current paths can be provided between first and second external contacts. An orthogonal set of axes XYZ is also illustrated in figures 4a to 4d. A similar set of axes will be used to describe the remaining figures.

The semiconductor devices 400a-d in figures 4a to 4d comprise a substrate 402a-d with a first surface 404a-d and a second surface 406a-d. The first and second surfaces 402a-d, 404a-d each extend in an X-Y plane. The second surface 406a-d is provided on a reverse face of the substrate to the first surface 404a-d. The first surface 404a-d may also be referred to as a front surface and the second surface 406 may also be referred to as a back surface, or opposing surface.

The semiconductor devices 400a-d in figures 4a to 4d comprise a plurality of units 415a-d. Each unit 415a-d provides a functional block for the semiconductor device, such as a transistor or diode unit. The units 415a-d may therefore be used in parallel in order to increase the current that can be handled by the device. Each unit 415a-d comprises a first trench 418a-d that extends from the first surface 404a-d towards the second surface 406a-d and a second trench 420a-d that extends from the second surface 406a-d towards the first surface 404a-d.

A first contact (not shown) is disposed on the first surface 404a-d of the substrate 402a-d in electrical contact with the first trench 418a-d. A second contact (not shown) is disposed on the second surface 406a-d of the substrate 402a-d in electrical contact with the second trench 420a-d. The first contact is not directly galvanically/electrically connected to the second contact; the first contact may therefore be considered to be separated from the second contact. The first contact is also separated from the second trench 420a-d and the second contact is also separated from the first trench 418a-d.

In order to reduce the resistance of the device 400a-d, the distance between the first and second contacts should be reduced or minimised. Advantageously, the devices 400a-d of figures 4a-d, and other devices disclosed below, can provide an acceptably short distance between the first and second contacts and therefore an acceptably low resistance.

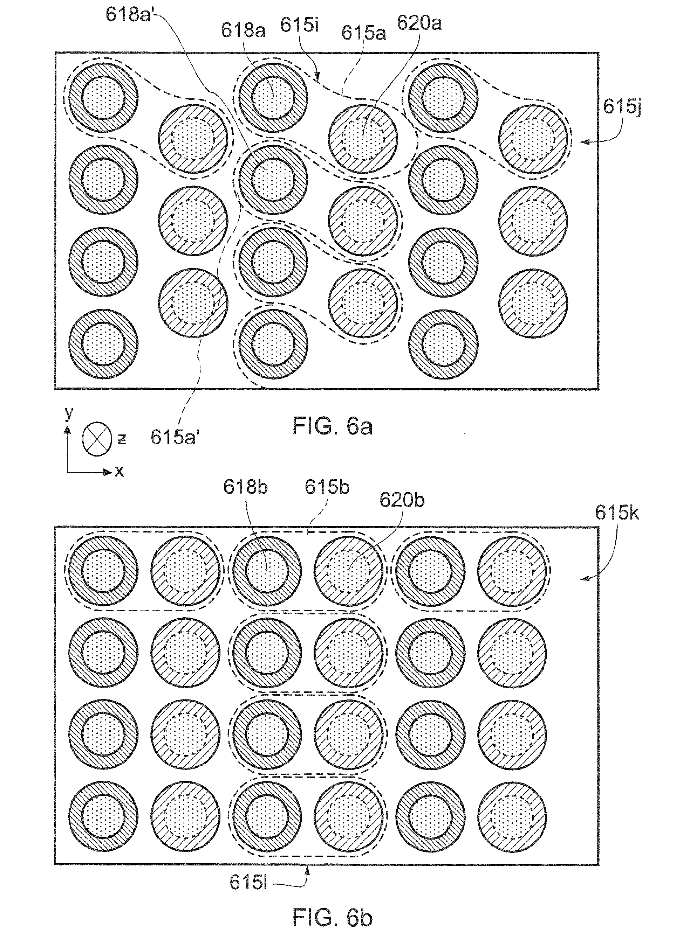

Each of the first and second trenches 418a-d, 420a-d extends in a Z direction that is normal to the X-Y plane. Such trenches may also be referred to as vertical trenches (with respect to a horizontal planar substrate). The first trench 418a-d is offset from the second trench 420a-d in the X direction. In these examples, the trenches 418a-d, 420a-d are planar structures that extend in a Y-Z plane. The trenches may be provided as columnar structures that extend in the same direction and have a cross-section in the X-Y plane in which the extent of the structure in the X direction is shorter than in the Z direction, for example. A variety of trench arrangements is described further with reference to figures 6a to 6d below.

In figures 4a to 4d the first and second trenches 418a-d, 420 a-d each contain electrically conductive material. In these examples the trenches 418a-d, 420a-d are filled with conductive material. Alternatively, the trenches may be only partially filled with electrically conductive material. The conductive material may be a metal, such as copper, or may be metallic. Preferably, the conductive material may be a semiconductor, such as polysilicon. The conductive material may have a conductivity greater than one of 10⁴ Sm⁻¹, 10⁵ Sm⁻¹, 10⁶ Sm⁻¹ or 10¹ Sm⁻¹ at 20 °C. The conductive material in the first trench 418a-d can be the same as the conductive material in the second trench 420a-d so that advantageously the resistivity of the trenches 418a-d, 420a-d is the same. The first and second contacts may contain the same conductive material as the first and second trenches 418a-d, 420a-d or a different conductive material.

The units 415a-d in figures 4a to 4d each comprise an active region 422a-d of the substrate 402a-d. The first trench 418a-d is separated from each second trench 420a-d by the active region 422a-d. The active region 422a-d may be the whole or part of a functional unit of the semiconductor device. The active region 422a-d comprises a plurality of layers extending transverse to the first surface, which separates the conductive material in the first trench 418a-d from the conductive material in the second trench 420a-d. In some applications it is advantageous for the resistance of the conductive material in the trenches 418a-d, 420a-d to be lower than the resistance of the active region 422a-d between the trenches 418a-d, 420a-d.

The layers can provide one or more PN junctions between the first and second trenches 418a-d, 420a-d. Each layer may be provided by a bulk layer of dopant within the substrate 402a-d and/or by layers of dopant diffused into the substrate via the trenches 418a-d, 420a-d. A plurality of diffused dopant layers can be formed around a trench by providing a deep diffusion layer and then over doping that layer with a shallower diffusion layer, for example. The deeper diffusion layer may have an opposite polarity to the shallow diffusion layer.

Each of the trenches 418a-d, 420a-d extends into the substrate 402a-d so that a portion of the first trench 418a-d faces a portion of the second trench 420a-d. A plurality of lateral current paths are provided between the facing portions of the trenches 418a-d, 420a-d. Each current path between the first and second contact (starting at either the first or second contact) passes through, or is defined by, in order:
first contact;
conductive material in the first trench 418a-d;
active region 422a-d;
conductive material in the second trench 420a-d; and
second contact.

Each of the current paths has the same, or a similar, path length between the first contact and the second contact. The resistance through each of these paths is therefore the same, or similar. For example, the current path length and resistance is the same for:
(i) a path through the entire length of the first trench 418a-d, across the active region 422a-d near the second surface 406a-d and through a short portion of the second trench 420a-d; and
(ii) a path through a short portion of the first trench 418a-d, across the active region 422a-d near the first surface 404a-d and through the entire length of the second trench 420a-d.

The devices 400a-d in figures 4a to 4d can have a relatively low resistivity (or high conductivity) because a relatively large volume of the device is used in the PN junctions in the active regions 422a-d. Also a relatively small distance may be provided between the first and second trenches, which also lowers the device resistance. The separation distance between the trenches 418a-d, 420a-d can be in the range of a few microns and controlled using lithography. In contrast, similar contact separation distances may be impracticable in vertical devices using conventional fabrication processes.

A significant advantage of the devices 400a-d in figures 4a to 4d over the arrangement of the diode illustrated in figure 3 is that a greater proportion of the depth of the substrate 402a-d in the Z direction can be used to provide lateral current paths. Also, the distribution of current between the various current paths is more uniform, providing improved breakdown characteristics and heat distribution properties compared to the device described with reference to figure 3.

Various trench arrangements are described below with regard to the specific examples in figures 4a to 4d.

In figure 4a the first and second trenches 418a, 420a extend through the substrate 402a from the first surface 404a to the second surface 406a such that the trenches 418a, 420a are exposed at both the first surface 404a and the second surface 406a. In figure 4b the first and second trenches 418b, 420b terminate within the substrate 402b. That is, in figure 4b the first trench 418b is not exposed at the second surface 406b and the second trench 420b is not exposed at the first surface 404b. An advantage of the structure of the device 400b in figure 4b is that a continuous first contact can be provided on the first surface 404b to provide an electrical connection to the first trench of each unit and a continuous second contact can be provided on the second surface 406b to provide an electrical connection to the second trench of each unit.

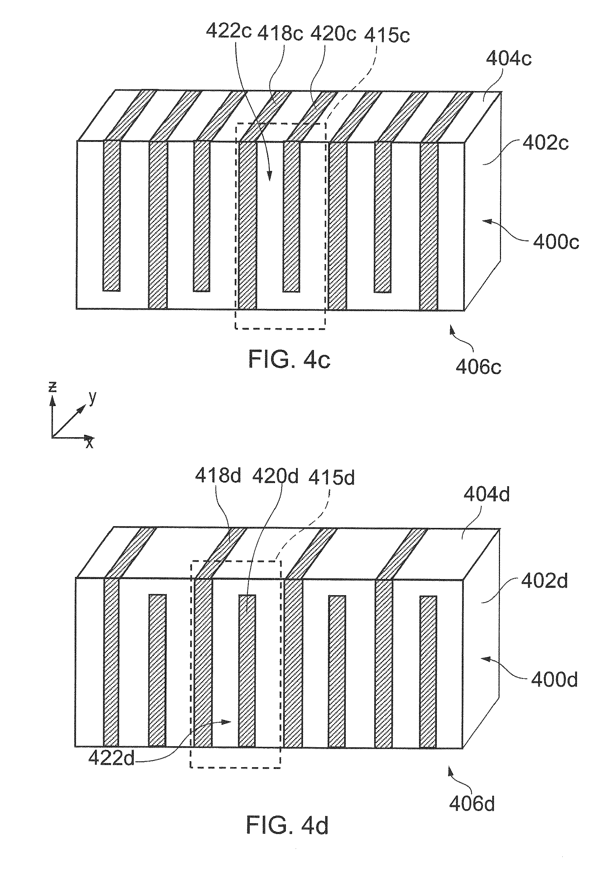

In figures 4c and 4d both trenches 418c-d, 420c-d extend from the same surface 404, 404d, one of the trenches 418c-d extends through the substrate 402c-d such that it is exposed at the opposing surface of the substrate 402c-d, and the other trench 420c-d terminates within the substrate 402c-d. In figure 4c, the first and second trenches 418c, 420c both extend from the first surface 404c. In figure 4d, the first and second trenches 418d, 420d both extend from the second surface 406d.

A trench that extends through the substrate such that it is exposed at an opposing surface can also be considered to extend from the first surface to the second surface, irrespective of the particular surface at which a fabrication process that formed the trench was initiated. In examples where both the first and second trenches 418c-d, 420c-d are exposed at the same surface, discontinuous first and second contacts may be provided in order to keep the first contact electrically separated from the second contact, or to keep the first contact electrically separated from the second trench and the second contact electrically separated from the first trench.

An advantage of the structures illustrated in figures 4c and 4d is that both the first and second trenches 418c-d, 420c-d can be etched or milled from a single surface (which in the example of figure 4c is the first surface 404c and in the example of figure 4d is the second surface 406d).

Example units and active regions are described below with reference to figures 5 to 13 for a variety of different types of semiconductor device.

Figures 5a and 5b illustrate in further detail a unit 515 for a semiconductor device. Figure 5a shows a cross-section of the unit 515 taken through the X-Z plane. Figure 5b shows a cross-section of the unit 515 taken through the X-Y plane.

The unit has a first active region 522 and a second active region 524. The first active region 522 is provided between conductive material 532 in the first trench 518 and conductive material 534 in the second trench 502. The second active region 524 is disposed in the substrate 502 on an opposite side (in the X direction) of the conductive material 534 in the second trench 520 to the first active region 522. A plurality of units 515, 517, 519 can be arranged such that the second active region 524 of a particular unit 515 is provided directly between the second trench 520 of the particular unit 515 and a first trench of a neighbouring unit 517.

In general, the first active region 522 comprises a plurality of layers extending transverse to the first surface 504 and separating the conductive material 532 in the first trench 418 from the conductive material 534 in the second trench 520. The layers need not necessarily extend through the entire thickness of the substrate. In this example, doped layers 526, 530 are provided surrounding the trenches 518, 522 and a low doped layer 528 is provided within the remaining bulk substrate 504.

In general, the second active region 524 of a particular unit 515 may comprise the same structure as the first active region of the particular unit 515, or a different structure. In this example, the second active region 524 provides a reversal, or mirror image of a structure of the first active region 522 of the unit 515. The structure of the layers 526, 528, 530 within the first active region 522 is discussed below in more detail with regard to a specific device.

Figure 5a illustrates a layer arrangement suitable for forming a diode 500, which is an example of a semiconductor device. The layers within each active region 522, 524 form a PN junction between electrical contacts (not shown) in order to provide the diode functionality.

The first active region 522 comprises a first doped layer 526, a second doped layer 530 and a low doped layer 528. The first doped layer 526 extends along the first trench 518 and the second doped layer 528 extends along the second trench 520. In this example, the first doped layer 526 is an N-type layer and the second doped layer 530 is a P-type layer. The low doped layer 528 is provided between the first trench 518 and the second trench 520 (in the X direction). More specifically the low doped layer 528 is provided between the first doped layer 526 and the second doped layer 530 (in the X direction). Each layer 526, 528, 530 extends in the Z direction, which is transverse to the first surface 504, and has a thickness in the X direction perpendicular to the Z direction.

The second active region 524 also comprises a first doped layer 536, a second doped layer 538 and a low doped layer 540. In the second active region 524, the first doped layer 536 is a P-type layer and the second doped layer 538 is an N-type layer. The first doped layer 536 extends along a first trench of the neighbouring unit 517. The second doped layer 538 extends along the second trench 520. The low doped layer 540 of the second active region 524 is provided between the first trench of the neighbouring unit 517 and the second trench 520. More specifically the low doped layer 528 is provided between the first doped layer 536 and the second doped layer 538. It will be appreciated that the second active region 524 will only be operational if the neighbouring unit 517 is connected such that a current flows through the neighbouring unit 517.

In this example, the second doped layer 530 of the first active region 522 is contiguous with the second doped layer 538 of the second active region 524. The first doped layer 526 of the first active region 522 is contiguous with a first doped layer of a second active region of a neighbouring unit 519.

Also in this example, the layers are non-planar, as shown in figure 5b. More specifically, doped layers are formed around trenches 518, 520 having circular cross-sections through a substrate layer. Alternatively, the layers may be planar and may be parallel with the first or second trenches 518, 520. Such an arrangement is possible, for example, where the trenches are elongate and extend in the Y direction as well as extending in the Z direction. In general, the trenches 518,520 may be cylindrical or prismatic; the trenches may be holes or slits in the substrate, depending on the production process capabilities available and the requirements for product performance. The trenches 518, 520 can be arranged in regular and symmetrical patterns in order to define a current distribution pattern, for example to optimise current distribution uniformity.

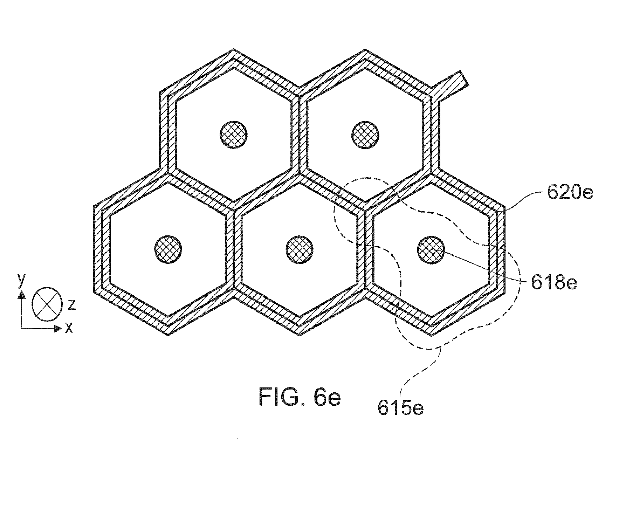

Figures 6a to 6e illustrate schematics of X-Y planes of a number of unit arrangements. The trenches 618a-d, 620a-d in figures 6a to 6d are provided as circular-based cylinders within units 615a-d. In figure 6e, a circular-based first trench 618e is surrounded by a hexagonal second trench 620e.

The plurality of units 615a-e have several axes of symmetry in the examples in figures 6a to 6e. The plurality of units 615a-e tessellate in order to provide a semiconductor device with a repeating pattern of similar units. In some examples, a plurality of units together form a functional unit. The reference to individual, repeating units is convenient in terms of defining the semiconductor device in terms of its topology, but an individual unit need not necessarily provide a functional unit on its own.

Figure 6a shows an example in which a centre of the second trench 620a of a particular unit 615a is offset in the Y direction from a centre of the first trench 618a. The centre of the second trench 620a is also offset in the X direction from the centre of the first trench 618a. Neighbouring units are arranged in a plurality of columns such that the first trench of each unit within a column 615i is aligned, in the X direction, with all of the other first trenches in that particular column 615i. A plurality of rows of units is also provided in each column. The first trench of each unit within a single row 615j is aligned, in the Y direction, with all of the other first trenches in that particular row 615j. The second trench 620a of the particular unit 615a is located at a midpoint, in the Y direction, between the first trench 618a of the particular unit 615a and a first trench 618a' of a neighbouring unit 615a' that is in the same column 615i as the particular unit 615a.

Figure 6b shows an example in which a plurality of rows and a plurality of columns of units 615b are provided. Centres of the first trench 618b and the second trench 620b within a particular unit 615b are aligned with each other in the Y direction and offset from one another in the X direction. The centres of the trenches in a row of units 615k are aligned in the Y direction. The centres of the first trenches of units in neighbouring rows (in a column of units 6151) are aligned in the X direction.

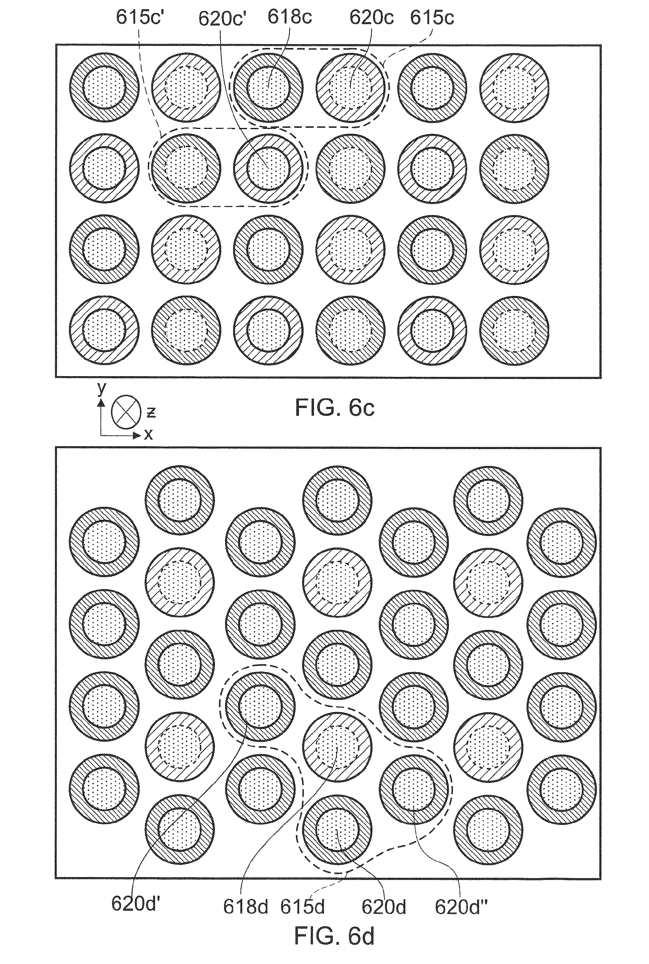

Figure 6c shows an example in which a plurality of rows and a plurality of columns of units 615c are provided. Centres of the first trench 618c and the second trench 620c within a particular unit 615c are aligned with each other in the Y direction and offset from one another in the X direction. The centres of the trenches of units in neighbouring columns are aligned in the Y direction. The centres of the first trenches of units in neighbouring row are offset from one another in the X direction such that the first trench of the particular unit 516c is adjacent to, and aligned in the X direction with, a second trench 620c' of a unit 615c' in a neighbouring row.

Figure 6d illustrates a hexagonal, or honeycomb, arrangement of trenches 618d, 620d, 620d', 620d". When a plurality of such units are provided, each first trench 618d is surrounded by a hexagonal arrangement of six second trenches. The arrangement is such that each first trench is separated from the first trench of a neighbouring unit by one or more second trenches. There are a number of equivalent ways of defining a unit for such an arrangement, one of which is illustrated in figure 6d. Each unit comprises one first trench 618d and three second trenches 620d, 620d', 620d".

Figure 6e illustrates an alternative to figures 6d in which the hexagonal arrangement of second trenches is replaced by a single hexagonal trench 618e which surrounds the first trench 620e.

An advantage of the arrangement illustrated in figures 6d and 6e compared to those of figures 6a to 6c is that the area of the PN junction can be increased per unit area of first surface.

In figure 6d and 6e, in order to provide a uniform current distribution along the length of the trenches 618d, 620d, 618e, 620e the resistivity of the first trench 618d, 618e can be made larger than the resistivity of the second trench 620d, 620e. For the hexagonal pattern shown, the resistivity of the first trench 618d, 618e may be three times greater than the resistivity of the second trench 620d, 620e. The relative resistivity of the trenches 618d, 620d, 618e, 620e may be set by selecting suitable trench diameters or by altering the conductivity of the conductive materials with the trenches 618d, 620d, 618e, 620e.

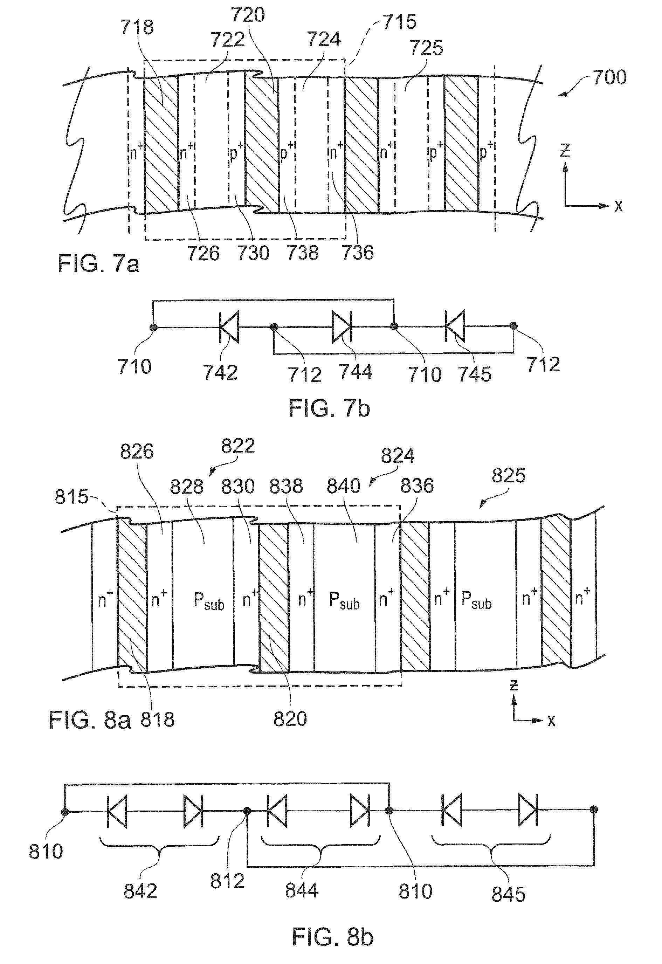

A number of different types of semiconductor device are described with reference to figures 7 to 13. In these examples, the first trenches have external connections at the first surface and the second trenches have external connections at the second surface. These semiconductor devices have active regions in which lateral current flow is achieved through a large portion of the thickness of the substrate (in the Z direction) and so device efficiency may be improved.

The specific examples below are described with reference to particular device arrangements. However, the skilled person will appreciate that the arrangement of N and P type layers of the transistor arrangement may be reversed in order, for example, to provide an NPN transistor instead of a PNP transistor. In general, any P- or P⁺-type layer described herein may be substituted for an N- or N⁺-type layer, or *vice versa.* P-type and N-type regions may simply be referred to as being of a first and second polarity, where the first polarity opposes the second polarity. A "+" sign indicates that a region is more heavily doped than a region that does not have a "+" sign.

Figure 7a illustrates a schematic cross-section through the X-Z plane for a diode comprising repeated units 715 which are similar to the unit described with reference to figure 5. The trenches may comprise holes (or columns) or slits (or planar regions extending in in the Y-Z plane).

Figure 7b provides an equivalent circuit diagram for the diode of figure 7a. Each of the active regions 722, 724, 725 in figure 7a provides the functionality of a corresponding diode 742, 744, 745 in figure 7b. Each diode 742, 744, 745 as an anode and cathode. Each cathode is provided at the first contact 710 in figure 7b by the first layer 726, 736 of one of the active regions 722, 724 in figure 7a. Each anode is provided at the second contact 712 in figure 7b by the second layer 730, 738 of one of the active region 722, 724 in figure 7a. In this way, the first contact 710 provides a common connection to each of the cathodes and the second contact 712 provides a common connection to each of the anodes.

Figure 8a illustrates a portion of a schematic cross-section for an anti-serial dual diode 800 comprising repeated units 815. The units of the dual diode arrangement 800 differ from the units described with reference to figure 7a in that:
- the second doped layers 830, 838 have the same conductivity type as the first doped layers 826, 836, which in the example shown is an N⁺-type layers; and
- the substrate 828 between the first layers 826, 836 and the respective second layers 830, 538 is doped with an opposing conductivity type to the first and second doped layers 826, 830, 836, 838. In this example, the substrate 828 is P-type.

The first and second doped layers 826, 830, 836, 838 may be formed by diffusing dopant through the trenches 818, 820. The respective first and second doped layers 826, 830, 836, 838 may be identical, in which case the electrical characteristics of the anti-serial diode 800 may be symmetrical for positive and negative applied voltages. Alternatively, the first doped layers 826, 836 may be different from the second doped layers 830, 838, in which case the breakdown voltage characteristics may be asymmetrical. For example, the breakdown voltages for positive voltages applied to one of the first and second trenches may be different from the breakdown voltages for positive voltages applied to the other of the first and second trenches.

Figure 8b provides an equivalent circuit diagram for the dual diode 800. Each of the active regions 822, 824, 825 in figure 8a provides the structure of a corresponding dual diode arrangement 842, 844, 845 in figure 8b. Each dual diode arrangement shown in figure 8b has a first diode and a second diode. Each diode has an anode and a cathode. Within each dual diode arrangement, the anode of the first diode is connected to the anode of the second diode. The cathode of the first diode is connected to the first terminal 810. The cathode of the second diode is connected to the second terminal 812. In this way, the first contact 810 provides a common connection to one side of the dual diode arrangement and the second contact 812 provides a common connection to another side of the dual diode arrangement.

The skilled person will appreciate that the arrangement of N and P type layers of the dual diode arrangement may be reversed, causing the polarity of the anode and cathode to be reversed.

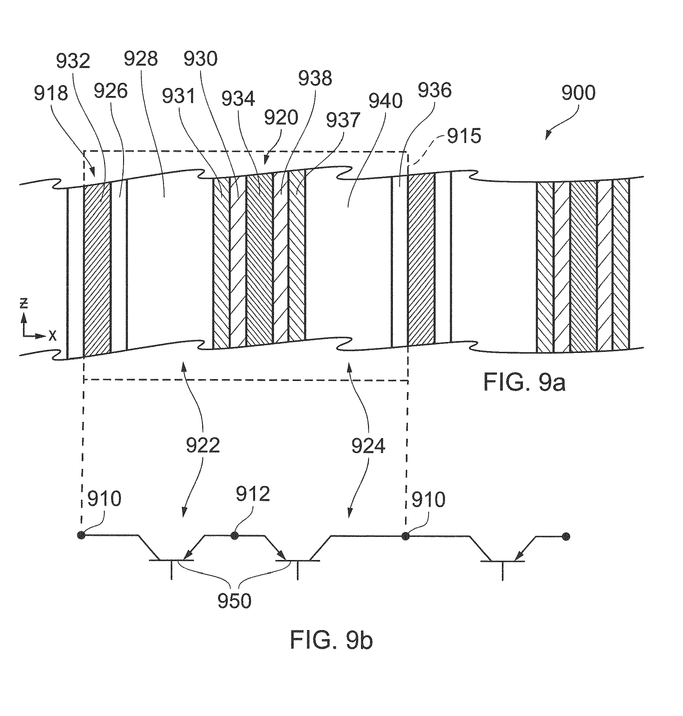

Figure 9a illustrates a schematic cross-section for an open base transistor or a Shockley diode comprising a plurality of units 915. Each unit 915 comprises a first active region 922 and a second active region 924.

The first active region 922 comprises a series of layers between conductive material 932 in the first trench 918 and conductive material 934 in the second trench 920. For an open base transistor, the order of layers between conductive material 932 in the first trench 918 and conductive material 934 in the second trench 920 is as follows:
a first layer 926 which has a first conductivity type (P⁺ in this example), extending along the first trench 918;
a doped substrate 928 of the first conductive type (P in this example);
an outer second layer 931 which has a second conductivity type (N in this example), extending along the second trench 920;
an inner second layer 930 of the first conductivity type (P⁺ in this example) extending along the second trench 920 between the outer second layer 931 and the conductive material 934.

The first layer 926 and the outer second layer 931 may be formed by diffusing dopant through the first trench 918. The outer second layer 931 may be formed by a diffusion through the second trench 920 that is then over doped by a shallower diffusion to form the inner second layer 930.

In this example the second active region 924 provides a mirror image of the structure of the first active region 922. That is, an X-Y plane of symmetry is present running along the centre of the second trench 920. The second active region 924 comprises the following sequence of layers from the conductive material in the first trench of an adjacent unit to the conductive material 934 in the second trench 920:
a first layer 936, which has the first conductivity type (P⁺ in this example) extending along the first trench 936;
a doped substrate 940 of the first conductive type (P in this example);
an outer second layer 937 of the second conductivity type (N in this example) extending along the second trench 920;
an inner second layer 938, which has the first conductivity type (P⁺ in this example) extending along the second trench 920 between the outer second layer 937 and the conductive material 934.

Figure 9b provides an equivalent circuit diagram for the open base transistor arrangement described with reference to figure 9a above. Each active region 922, 924 shown in figure 9a provides the functional unit of a bipolar transistor 950 in figure 9b. Each transistor 950 has:
a floating base in figure 9b provided by the outer second layer 931, 937 in figure 9a,
a collector in figure 9b provided by the first layer 926, 936 in figure 9a, the collector is connected to the first contact 910 by conductive material 932 in the first trench 918 in figure 9a and
an emitter provided by the inner second layer 930, 938 in figure 9a, the emitter is connected to the second contact 912 by conductive material 934 in the second trench 920 in figure 9a.

The layers in the anti-serial dual diode of figure 8 or the open base transistor of figure 9 may be arranged such that the two space charge regions of the PN junctions overlap at a positive and/or negative applied bias voltage, referred to as a punch voltage.

A Shockley diode can also be provided using the arrangement shown in figure 9a. In a Shockley diode, a P-N-P-N (or N-P-N-P) layer sequence is provided within each active region. For example, if the structure shown in figure 9a were configured as a Shockley diode, the first active region 922 comprises the following sequence of layers from the conductive material 932 in the first trench 918 to the conductive material 934 in the second trench 920:
a first layer 926 of the second conductivity type (N in this example), extending along the first trench 918;
a layer of doped substrate 928 of the first conductivity type (P in this example);
an outer second layer 931 of the second conductivity type (N in this example), extending along the second trench 920;
an inner second layer 930 of the first conductivity type (P in this example) extending along the second trench 920 between the outer second layer 931 and the conductive material 934 in the second trench 920.

The second active region is a mirror of the first active region as shown in figure 9a. For a Shockley diode, the second active region 924 comprises the following sequence of layers from the conductive material in the first trench of a neighbouring unit to the conductive material 934 in the second trench 922:
a first layer 936 of the second conductivity type (N in this example) extending along the first trench of the neighbouring unit;
a layer of doped substrate 940 of the first conductivity type (P in this example);
an outer second layer 937 of the second conductivity type (N in this example) extending along the second trench 920;
an inner second layer 938 of the first conductivity type (P in this example) extending along the second trench 920 between the outer second layer 937 and the conductive material 934 in the second trench 920.

A thyristor with a gate contact on one side may be provided using a similar arrangement to the Shockley diode. However, for the thyristor, one of the two bases is connected with a third contact (not shown) on top of the substrate in order to provide a gate terminal.

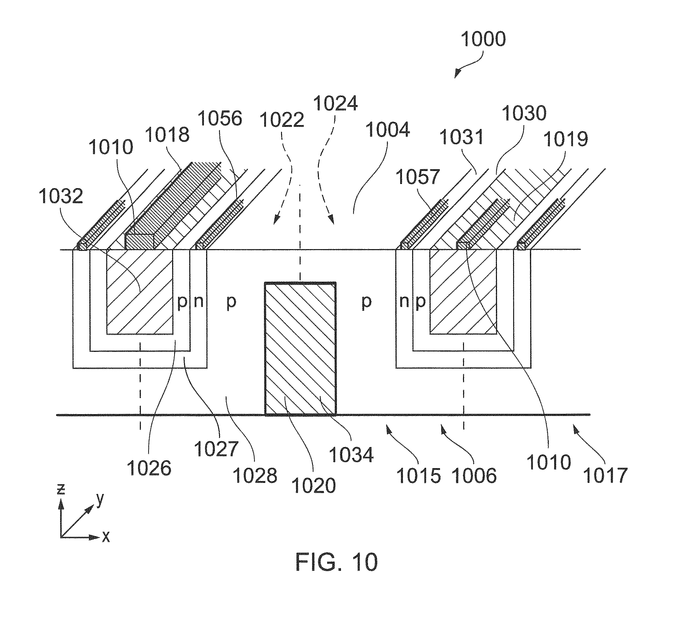

Figure 10 illustrates a schematic cross-section for a bipolar transistor 100 comprising a plurality of units 1015, 1017. Each unit 1015, 1017 comprises a first active region 1022 and a second active region 1024. Each active region 1022, 1024 provides an individual transistor functional unit.

The first active region 1022 of a particular unit 1015 comprises a series of layers between conductive material 1032 in the first trench 1018 and conductive material 1034 in the second trench 1020. The order of layers from the conductive material 1032 in the first trench 1018 to the conductive material 1034 in the second trench 1020 is as follows in the first active region 1022:
an inner first layer 1026 of a first conductivity type (P in this example) extending along the first trench 1018;
an outer first layer 1027 of a second conductivity type (N in this example) extending along the first trench 1018 such that the inner first layer 1026 is provided between the outer first layer 1027 and the conductive material 1032; and
a layer of doped substrate 1028 of the first conductivity type (P in this example).

In this example there are no additional layers provided between the conductive material 1034 in the second trench 1020 and the doped substrate 1028. Alternatively, a second layer of the first conductivity type (P in this example) may optionally be provided extending along the second trench 1020.

A base contact 1056 is provided on the first surface 1004 in the first active region 1022. The base contact 1056 is electrically connected to the outer first layer 1027. The first contact 1010 provides an emitter contact that is electrically connected to the inner first layer 1026. The second contact (not shown) provides a collector contact that is electrically connected to the layer of doped substrate 1028.

In this example the second active region 1024 provides a mirror image of the structure of the first active region 1022. The order of layers from the conductive material in a first trench 1019 of a neighbouring unit 1017 to the conductive material 1034 in the second trench 1020 in the second active region 1024 is as follows:
an inner first layer 1030 of the first conductivity type (P in this example) extending along the first trench 1019 of the adjacent unit 1017;
an outer first layer 1031 of the second conductivity type (N in this example) extending along the first trench 1019 of the neighbouring unit 1017 such that the inner first layer 1030 is between the outer first layer 1031 and the conductive material in the first trench 1019 of the adjacent unit 1017; and
a layer of doped substrate 1028 of the first conductivity type (P in this example).

A base contact 1057 is also provided on the first surface 1004 for the functional transistor provided by the second active region 1024. The base contact 1057 is electrically connected to the outer first layer 1031. The first contact 1010 provides an emitter contact that is electrically connected to the inner first layer 1030. The second contact (not shown) provides a collector contact that is electrically connected to the layer of doped substrate 1028.

A thyristor with a gate contact on one side may be provided using a similar arrangement to the bipolar transistor of figure 10. For the thyristor, a second layer of an opposite conductivity type to the layer of doped substrate 1028 is provided around the second trench 1020.

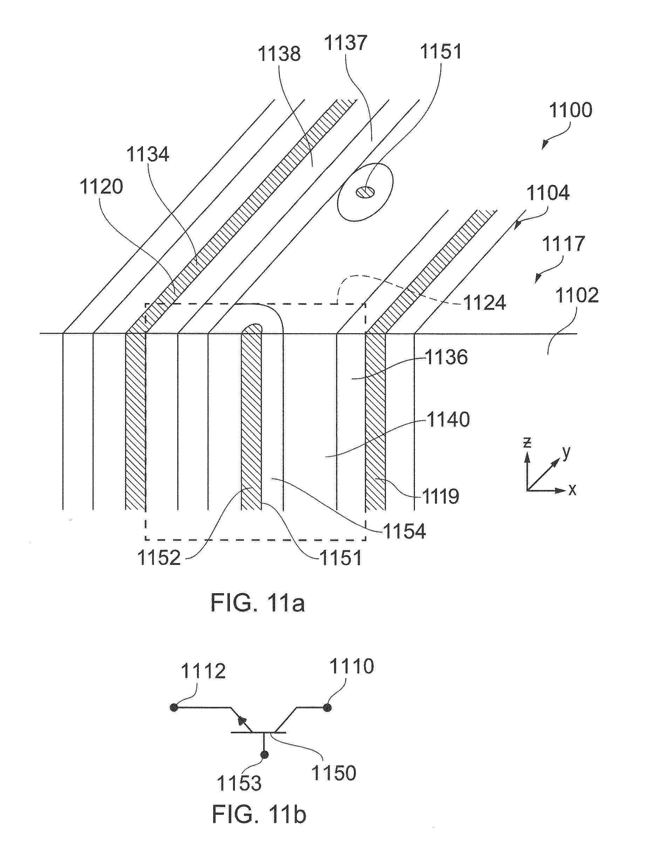

Figure 11 a illustrates a schematic cross-section of a second active region 1124 for another bipolar transistor 1100. The structure of the bipolar transistor 1100 is similar to the bipolar transistor described with reference to figure 9a but in addition comprises a third trench 1151 within each active region.

The first trench 1119 shown in this example is part of a neighbouring unit 1117. In this example, the first and second trenches 1119, 1120 both extend from the first surface 1104. One of the first and second trenches 1119, 1120 terminates within the substrate 1102, the other of the trenches extends through the substrate 1102 such that it is exposed at the opposing surface of the substrate 1102.

The first and second trenches 1119, 1120 are provided as Y-Z planar trenches that extend transverse to the first surface 1104 and have a thickness in the X direction. A series of columnar third trenches 1151 is provided between the first and second trenches 1119, 1120. The third trenches 1151 extend from the first surface 1104 and are separated from each other in the Y direction so as to form an intermittent conductor (in the Y direction) within the substrate 1102.

The second active region 1124 comprises the following sequence of layers from the conductive material in the first trench 1119 of a neighbouring unit 1117 to the conductive material 1134 in the second trench 1120 (working from right to left in figure 11):
a first layer 1136 of a second conductivity type (N⁺ in this example) extending along the first trench 1119;
a layer of doped substrate 1140 of the second conductivity type (N in this example), within which is the series of third trenches 1151, each of the third trenches 1151 comprising a core of conductive material 1152 surrounded by a semiconductor layer 1154 of a first conductivity type (P⁺ in this example);
an outer second layer 1137 of the first conductivity type (P in this example) extending along the second trench 1120;
an inner second layer 1138 of a second conductivity type (N⁺ in this example) extending along the second trench 1120 between the outer second layer 1137 and the conductive material 1134.

Figure 11b provides an equivalent circuit diagram for the transistor arrangement described with reference to figure 11a above. The second active region 1124 in figure 11a provides the functional unit of a bipolar transistor 1150 in figure 11 b. The conductive material in the first trench 1119 in figure 11 a is connected to the first contact 1110 (which provides the collector contact of the transistor 1150 in figure 11 b). The conductive material 1134 in the second trench 1120 in figure 11 a is connected to the second contact 1112 (which provides the emitter contact of the transistor 1150 in figure 11 b) The third trench 1151 in figure 11 a is connected to a third contact 1153 (which provides the base contact of the transistor 1150 in figure 11 b).

Layers 1154 and 1137 overlap each other. In that way can the base of the transistor 1137 be electrically controlled / contacted via diffusion 1154 and the third trenches

The first active region of the semiconductor device 1100 may be provided as a mirror of the structure of the second active region 1124.

A thyristor with a gate contact on one side may be provided using a similar arrangement to the bipolar transistor of figure 11. For the thyristor, the first layer 1136 extending along the first trench 1119 has the opposite conductivity type to the layer of doped substrate 1140. In the current example, the first layer 1136 is P doped, the substrate layer 1140 is N doped, the outer second layer 1137 is P doped and the inner second layer 1138 is N doped.

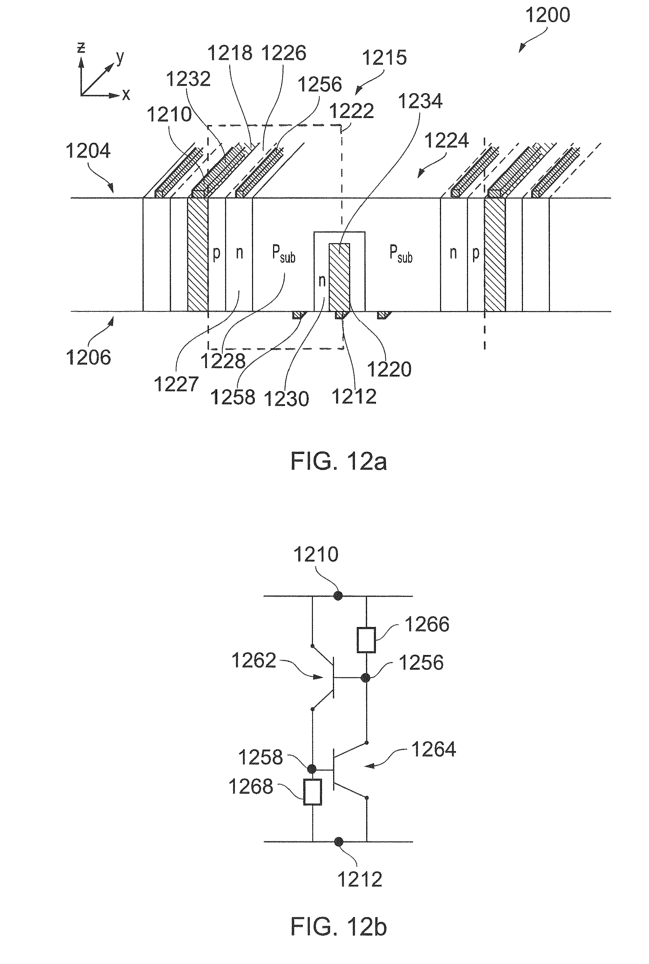

Figure 12a illustrates a schematic cross-section for a unit 1215 comprising a first active region 1222 and a second active region 1224 of a silicon controlled rectifier (SCR) 1200. A first SCR unit is provided by the first active region 1222 and a second SCR unit is provided by the second active region 1224.

The first and second trenches 1218, 1220 are provided as Y-Z planar trenches that extend transverse to the first surface 1204 and have a thickness in the X direction. The first trench 1218 extends between the first surface and the second surface such that it is exposed at the first and second surfaces. The second trench 1220 extends from the second surface 1206 and terminates within the substrate.

The first active region 1222 comprises the following sequence of layers from the conductive material 1232 in the first trench 1218 to the conductive material 1234 in the second trench 1220:
an inner first layer 1226 of a first conductivity type (P in this example) extending along the first trench 1218;
an outer first layer 1227 of a second conductivity type (N in this example) extending along the first trench 1218 such that the inner first layer 1226 is between the outer first layer 1227 and the conductive material 1232 in the first trench 1218;
a layer of doped substrate 1228 of a first conductivity type (P in this example); and
a second layer 1230 of the second conductivity type (N in this example).

The following contacts are provided on the first surface 1204 for the first active region 1222:
a first surface contact 1210 for providing an electrical connection to the conductive material 1232 in the first trench 1218; and
a first transistor base contact 1256 for making an electrical connection to the base of a (PNP, in this example) structure comprising the inner first layer 1226, the outer first layer 1227 and the layer of doped substrate 1228.

The following contacts are provided on the second surface 1206 for the first active region 1222:
a second surface contact 1212 for providing an electrical connection to the conductive material 1234 in the second trench 1220;
a contact 1258 for making an electrical connection to the layer of doped substrate 1228.

The second active region 1224 of the silicon controlled rectifier 1200 is provided as a mirror of the structure of the first active region 1222.

Figure 12b illustrates a circuit diagram corresponding to the silicon controlled rectifier 1200 of figure 12a. The silicon controlled rectifier 1200 comprises a first bipolar junction transistor 1262 and a second bipolar junction transistor 1264. Each transistor 1262, 1264 has a base and a conduction path.

In figure 12b, the base of the first transistor 1262 is connected to the first transistor base contact 1256 and provided by the outer first layer 1227 in figure 12a. The base of the first transistor 1262 is connected to the first contact 1210 by a first resistor 1266, which is also formed by the outer first layer 1227 in figure 12a.

In figure 12b, the base of the second transistor 1264 is connected to the second transistor base contact 1258 and provided by the layer of doped substrate 1228 in figure 12a. The base of the second transistor 1264 is connected to the second contact 1212 by a second resistor 1268, which is also formed by the layer of doped substrate 1228 in figure 12a. The conduction path of the first transistor 1262 is provided in series with the second resistor 1268 between the first contact 1210 and the second contact 1212.

The conduction path of the second transistor 1264 is provided in series with the first resistor 1266 between the first contact 1210 and the second contact 1212.

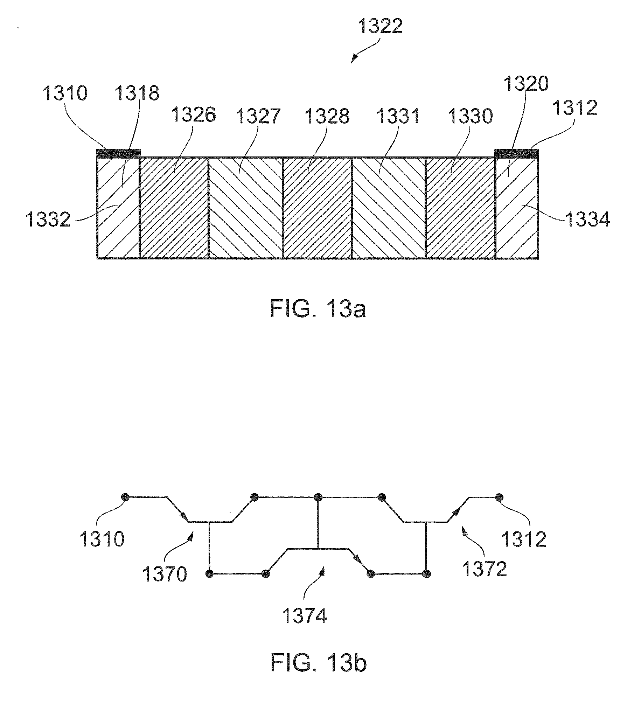

Figure 13a and 13b illustrate an arrangement of layers for an active region 1322 of a semiconductor device for providing a thyristor assisted anti-serial diode and a corresponding circuit diagram. The sequence of such a thyristor assisted anti-serial diode is P-N-P-N-P or N-P-N-P-N.

The active region 1322 illustrated in figure 13a comprises the following sequence of layers from the conductive material 1332 in the first trench 1318 to the conductive material 1334 in the second trench 1320:
an inner first layer 1326 of a first conductivity type (P in this example) extending along the first trench 1318;
an outer first layer 1327 of a second conductivity type (N in this example) extending along the first trench 1318 such that the inner first layer 1326 is between the outer first layer 1327 and the conductive material 1332 in the first trench 1318;
a layer of doped substrate 1328 of the first conductivity type (P in this example);
an outer second layer 1331 of the second conductivity type (N in this example) extending along the second trench 1320; and
an inner second layer 1330 of the first conductivity type (P in this example), extending along the second trench 1320 between the outer second layer 1331 and the conductive material 1334 in the second trench 1320.

Figure 13b illustrates a circuit diagram corresponding to the active region 1322 of thyristor illustrated in figure 13a. The circuit in figure 13b comprises a first transistor 1370, a second transistor 1372 and a third transistor 1374. Each transistor 1370, 1372, 1374 comprises a base, a collector and an emitter. A conduction path is provided between the collector and emitter of each transistor 1370, 1372, 1374. The first and second transistors 1370, 1372 are PNP transistors in this example. The conduction path of the first transistor 1370 is provided in series with the conduction path of the second transistor 1372 between the first contact 1310 and the second contact 1312.

The emitter of the first transistor 1370 in figure 13b is connected to the first contact 1310 and is provided by the inner first layer 1326 in figure 13a. The collector of the first transistor 1370 is connected to the collector of the second transistor 1372 in figure 13b. The collectors of the first and second transistors 1370, 1372 in figure 13b are provided by the layer of doped substrate 1328 in figure 13a. The emitter of the second transistor 1372 in figure 13b is connected to the second contact 1312 and is provided by the inner second layer 1330 in figure 13a.

The third transistor 1374 is an NPN transistor in this example. The base of the third transistor 1374 in figure 13b is connected to the collector of the first and second transistors 1370, 1372 and is also provided by the layer of doped substrate 1328 in figure 13a. The collector of the third transistor 1374 in figure 13b is connected to the base of the first transistor 1370 and is provided by the outer first layer 1327 in figure 13a. The emitter of the third transistor 1374 in figure 13b is connected to the base of the second transistor 1372 and is provided by the outer second layer 1331 in figure 13a.

Any of the semiconductor devices described herein with reference to figures 4 to 13 may comprise one or more additional contacts disposed on the first surface. The additional contacts can be connected to respective contacts on the second surface, such as the second contact, using a via or an additional trench through the substrate. In this way, assembly of the semiconductor device in a package may be simplified because all of the external contacts can be provided on one side of the substrate/package.

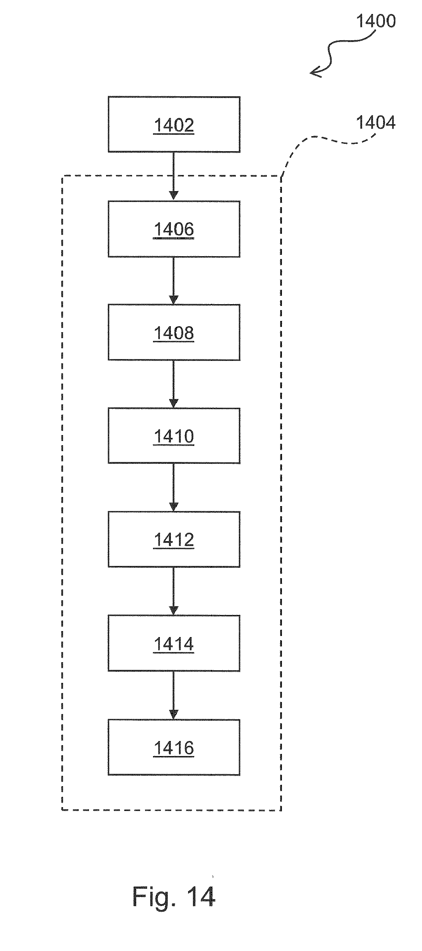

Figure 14 illustrates a method 1400 for manufacturing a semiconductor device from a substrate having a first surface and an opposing second surface. The method comprises:
optionally, doping 1402 the bulk substrate;
forming 1404 a unit in the semiconductor device by:
   preparing 1406 a first trench extending from the first surface towards the second surface;
   preparing 1408 a second trench extending from the second surface towards the first surface;
   forming 1410 a first active region by diffusing dopant into the substrate via the first and/or second trenches, the first active region comprising a plurality of layers extending transverse to the first surface;
   filling 1412 the first and second trenches with conductive material;
   disposing 1414 a first contact on the first surface of the substrate in electrical contact with the conductive material in the first trench;
   disposing 1416 a second contact on the second surface of the substrate in electrical contact with the conductive material in the second trench.

Each of the plurality of layers has a first or second conductivity type. The first conductivity type is of a different type to the second conductivity type, such as P- and N-type. The optional doped bulk substrate may provide one of the layers. The plurality of layers may provide one or more PN junctions within the first active region. The method may comprise forming a plurality of units such as those described with reference to figures 4 to 13.

The method may comprise diffusing into the substrate, via the first and/or second trenches, a layer in an active region between the first and second trenches. The layer may have the first conductivity type. The method may comprise:
diffusing into the substrate via a particular trench an outer layer having a first depth and the second conductivity; and
diffusing into the substrate via the particular trench an inner layer having a second depth and the first conductivity, wherein the first depth is deeper than the second depth. In this way, two or more layers can be formed around the particular trench. The particular trench may be the first trench or the second trench.

The trenches may be prepared by any suitable etching or milling technique. Both of the trenches may be prepared from the same surface, for example by etching from the same surface, in order to reduce the number of fabrication steps. The trenches may be deep enough so that at least 100 µm of the first trench faces the second trench to form a lateral conduction path. The first and second trenches may extend to within 10 µm of a surface that opposes the surface at which they enter the substrate. The substrate may have a thickness of about 200 µm, for example. A pore or micro-pore may be considered to provide a trench

The substrate may be provided by a silicon wafer. The substrate may be thinned, for example by grinding from the back surface. The thinning step may occur after the diffusion step. The thinning step may occur before the filling step. The thinning step may occur before contacts are applied. The filling step may occur before contacts are applied.

It will be appreciated that any components that are described herein as being coupled or connected could be directly or indirectly coupled or connected. That is, one or more components could be located between two components that are said to be coupled or connected whilst still enabling the required functionality to be achieved.

Throughout the present specification, descriptors relating to relative orientation and position, such as "top", "bottom", "upper", "lower", "above" and "below", as well as any adjective and adverb derivatives thereof, are used in the sense of the orientation of the apparatus as presented in the drawings. However, such descriptors are not intended to be in any way limiting to an intended use of the described or claimed apparatus.

## Claims

1. A semiconductor device comprising:
a substrate with a first surface and an opposing second surface; and
a unit comprising:
a first trench extending from the first surface towards the second surface and a second trench extending from the second surface towards the first surface, wherein the first and second trenches contain conductive material;
a first contact disposed on the first surface of the substrate in electrical contact with the first trench;
a second contact disposed on the second surface of the substrate in electrical contact with the second trench; and
a first active region comprising a plurality of layers extending transverse to the first surface and separating the conductive material in the first trench from the conductive material in the second trench.

2. The semiconductor device of claim 1 wherein the first trench and/or second trench terminates within the substrate.

3. The semiconductor device of claim 1 wherein the first trench and/or second trench extends through the substrate such that it is exposed at the first and second surfaces.

4. The semiconductor device of any preceding claim wherein layers of the first active region form a PN junction, wherein a P side of the junction is adjacent to the first trench and an N side of the junction is adjacent to the second trench.

5. The semiconductor device of any preceding claim wherein the first active region comprises two opposing diodes or a Shockley diode.

6. The semiconductor device of any preceding claim wherein the unit comprises a third trench extending from the first surface towards the second surface, wherein the third trench contains conductive material.

7. The semiconductor device of any preceding claim wherein the first active region comprises one or more of a bipolar transistor, a thyristor, or a silicon controlled rectifier.

8. The semiconductor device of any preceding claim comprising an additional contact disposed on the first surface, wherein the additional contact is connected to the second contact through the substrate.

9. The semiconductor device of any preceding claim wherein the first active region at least partly forms a vertical trench device.

10. The semiconductor device of any preceding claim comprising a plurality of units.

11. The semiconductor device of claim 10 wherein each unit comprises a second active region disposed in the substrate on an opposite side of the second trench to the first active region, wherein the plurality of units is arranged such that the second active region of a particular unit is provided directly between the second trench of that unit and a first trench of a neighbouring unit.

12. The semiconductor device of claim 11 wherein the second active region of each unit comprises the same structure as the first active region of that unit.

13. The semiconductor device of claim 11 wherein the second active region of each unit comprises a reversal of a structure of the first active region of the respective unit.

14. The semiconductor device of any of claims 10 to claim 13 wherein the plurality of units have one or more axes of symmetry as viewed normal to a plane of the first surface.

15. A method for manufacturing a semiconductor device from a semiconductor substrate having a first surface and an opposing second surface, the method comprising:
forming a unit in the semiconductor device by:
preparing a first trench extending from the first surface towards the second surface;
preparing a second trench extending from the second surface towards the first surface;
forming a first active region by diffusing dopant into the substrate via the first and/or second trenches, the first active region comprising a plurality of layers extending transverse to the first surface;
filling the first and second trenches with conductive material;
disposing a first contact on the first surface of the substrate in electrical contact with the conductive material in the first trench;
disposing a second contact on the second surface of the substrate in electrical contact with the conductive material in the second trench.
